Europäisches Patentamt

European Patent Office

Office européen des brevets

(11) Veröffentlichungsnummer: **0 315 707 B1**

(12) **EUROPÄISCHE PATENTSCHRIFT**

(45) Veröffentlichungstag der Patentschrift: **22.04.92**

(21) Anmeldenummer: **87116528.8**

(22) Anmeldetag: **09.11.87**

(51) Int. Cl.⁵: **G01R 1/073**

(54) **Adapter für eine Vorrichtung zur elektronischen Prüfung von Leiterplatten.**

(43) Veröffentlichungstag der Anmeldung:
**17.05.89 Patentblatt 89/20**

(45) Bekanntmachung des Hinweises auf die
Patenterteilung:
**22.04.92 Patentblatt 92/17**

(84) Benannte Vertragsstaaten:
**AT BE CH DE ES FR GB IT LI LU NL SE**

(56) Entgegenhaltungen:
EP-A- 0 026 824    EP-A- 0 215 146
EP-A- 0 233 511    DE-A- 3 524 229
DE-B- 1 272 048    US-A- 4 099 120
US-A- 4 626 776

(73) Patentinhaber: **MANIA GmbH & Co.**
**Technologiepark**
**W-6395 Weilrod 8(DE)**

(72) Erfinder: **Mang, Paul**
**Weilbergstrasse 4**
**W-6384 Schmitten 3(DE)**
Erfinder: **Arampoglou, Savvas**
**Am Fasanengarten 2**
**W-6277 Bad Camberg(DE)**

(74) Vertreter: **Ruschke, Hans Edvard et al**
**Patentanwälte Dipl.-Ing. Olaf Ruschke**
**Dipl.-Ing. Hans E. Ruschke Dipl.-Ing. Jürgen**
**Rost Dipl.-Chem. Dr. U. Rotter Pienzenauer-**
**strasse 2**
**W-8000 München 80(DE)**

**Beschreibung**

Die vorliegende Erfindung betrifft einen Adapter zur Anpassung des gleichmäßigen Kontaktrasters einer elektronischen Prüfvorrichtung für Leiterplatten an die ungleichmäßige Kontaktkonfiguration der Anschlußpunkte auf einer zu prüfenden Leiterplatte gemäß dem Oberbegriff des Patentanspruches 1.

Der "Universaladapter" gemäß der EP-B1-26 824 weist eine auf dem Grundraster der Prüfvorrichtung aufliegende Grundplatte auf, die entsprechend dem gleichmäßigen Kontaktraster der Prüfvorrichtung mit durchgehenden Kanälen oder Bohrungen versehen ist. In einiger Entfernung über dem Grundraster, d.h. auf der vom Grundraster der Prüfvorrichtung abgewandten Seite der Grundplatte wird eine Anordnung aus von zwei zueinander beabstandeten Adapterplatten mit Hilfe von festen Abstandshaltern angeordnet. Diese Adapterplatten sind identisch mit Bohrungen versehen, die entsprechend den Anschlußpunkten der zu prüfenden Leiterplatte verteilt sind. In diese Bohrungen in den Adapterplatten werden dann nadelförmige, in Längsrichtung federnde Prüfstifte eingesetzt, die zum Ausgleich von eventuellen Fluchtungsfehlern zwischen den genannten Bohrungen und den Kanälen zumindest in ihrem unteren Abschnitt quer zur Längserstreckung der Prüfstifte federnd auslenkbar sind. Der Adapter ist im übrigen mit einer Ausrichtvorrichtung versehen, die die zu prüfende Leiterplatte auf den Adapter ausrichtet. Dies geschieht etwa durch geeignete Fixierstifte, die in entsprechend angeordnete Fixierbohrungen im Prüfling eingreifen. Aufgrund der prüflingsspezifisch identisch gebohrten, einen gewissen Abstand zueinander aufweisenden zwei (inneren und äußeren) Adapterplatten wird sichergestellt, daß die Prüfstifte in ihrem der Leiterplatte benachbarten Bereich exakt vertikal zur Leiterplattenoberfläche verlaufen und somit genau mit den Anschlußpunkten auf der zu prüfenden Leiterplatte in Kontakt kommen, auch wenn der weiter entfernt von der Leiterplatte liegende untere Bereich der Prüfstifte ausgelenkt sein sollte.

Da bei komplexen Leiterplatten viele tausend Anschlußpunkte vorgesehen sein können und für jeden Anschlußpunkt ein federnder Prüfstift benötigt wird, steigen die Kosten für einen solchen Adapter mit der Zahl der Anschlußpunkte sehr stark an, da in Längsrichtung federnde Prüfstifte einen nicht unerheblichen Fertigungsaufwand erfordern. Es kommt hinzu, daß solche Prüfstifte einen kaum zu unterschreitenden Mindestdurchmesser haben, der die natürliche Grenze für die mögliche Prüfstiftdichte darstellt.

Um in Längsrichtung starre, und somit einfach herzustellende und besonders dünne Prüfstifte verwenden zu können, wurde ein "aktives Grundraster" geschaffen, bei dem die Kontakte des Grundrasters der Leiterplattenprüfvorrichtung im wesentlichen in Richtung der Längsachse der Prüfstifte federnd gelagert sind. Dieses aktive Grundraster wird auf das starre, fest verdrahtete Grundraster der Leiterplattenprüfvorrichtung aufgesetzt und dient dazu, bei der Verwendung von starren Prüfstiften für einen ausreichend hohen und möglichst gleichmäßigen Kontaktdruck bei allen von den starren Prüfstiften kontaktierten Prüfpunkten zu sorgen.

Die EP-A1-0 215 146 zeigt einen gattungsgemäßen Adapter ("Adapter 85"), dessen obere prüflingsspezifisch gebohrte Adapterplatte an der zu prüfenden Leiterplatte anliegt und dessen starre konturlose Prüfstifte eine zusätzliche elastische Platte durchsetzen, die aufgrund der Elastizität des Materials die Prüfstifte beim Hantieren mit dem Adapter unabhängig von der eigentlichen Prüfvorrichtung am Herausfallen hindern. Dadurch kann bei einer späteren Prüfung von gleichen Leiterplatte der nicht unerhebliche Arbeitsaufwand zu Bestücken des Adapters gespart werden und stattdessen der Adapter bis zur erneuten Verwendung wieder aufbewahrt werden. Dieser Adapter bringt zwar den Vorteil, daß sehr billig herzustellende starre und völlig konturlose Prüfstifte verwendet werden können, doch wird die Bestückung des Adapters dadurch komplizierter, daß die Prüfstifte nicht einfach in den Adapter "hineinfallen" können, sondern durch die elastische Platte mit einem gewissen Kraftaufwand hindurchgedrückt werden müssen. *)

Die EP-A1-0 233 511 zeigt einen gattungsähnlichen Adapter, allerdings zum Prüfen von Chips aufweisende Wafers. Dieser Adapter weist eine Grundplatte und eine äußere Führungsplatine auf, die prüflingsspezifisch gebohrte Führungskanäle für die Prüfnadeln besitzt und gegebenenfalls federnd auf dem Prüfling zur Anlage kommt, wobei die Nadelspitzen an den Kontaktflächen des Prüflings angreifen. Um den an sich starren Nadeln dennoch eine gewisse Nachgiebigkeit in Längsrichtung zu erteilen, ist eine zweite innere Führungsplatine vorgesehen, deren Aufgabe es ist, die Nadeln seitwärts ausgebogen zu halten, um dadurch eine axiale Federung zu erreichen. Zu diesem Zweck ist die Lochanordnung der inneren Führungsplatine gegenüber der äußeren Führungsplatine entweder horizontal versetzt oder größer oder kleiner gehalten. Eine derartige Anordnung der starren Prüfstifte verbietet sich aber bei Leiterplatten-Adaptern von selbst, weil die häufig

---

*) Weiterhin weist dieser Adapter eine innere Adapterplatte auf, deren Raster jedoch weder dem Raster der äußeren Adapterplatte noch dem der Grundplatte entspricht.

außerordentlich zahlreichen Prüfstifte im Interesse eines raschen Aufbaus des Adapters auf die Bohrungen der beiden Führungsplatinen ausgerichtet sein müssen, ohne daß jeder Prüfstift einzeln, z.B. von Hand eingefädelt werden müßte.

Die voranstehend abgehandelten Adapter sind für die einseitige Prüfung von Leiterplatten konzipiert worden. Es kommen jedoch zunehmend Leiterplatten zum Einsatz. die beidseitig mit Anschlußpunkten versehen sind, d.h.. sie müssen auch von beiden Seiten geprüft werden. Dabei kann man sich zwar mit zwei aufeinanderfolgenden einseitigen Prüfungen behelfen, doch wird man dabei jedenfalls keine solchen Leitungsunterbrechungen feststellen können, die zudem im Hinblick auf Leitungsunterbrechungen besonders empfindlich sind. Daher sind Leiterplattenprüfvorrichtungen entwickelt worden, die in der Lage sind, eine gleichzeitige beidseitige Prüfung von doppelseitig bestückbaren Leiterplatten vorzunehmen. Dies führt dann auch zur Notwendigkeit von Adaptern für derartige Prüfvorrichtungen. Leider sind die bisher entwickelten Adapter nur in Ausnahmefällen für die gleichzeitige beidseitige Prüfung verwendbar, denn wenn die Anschlußpunkte auf beiden Seiten der zu prüfenden Leiterplatte ungleichmäßig verteilt sind, kommt es bei den bisweilen vielen tausend Prüfstiften zu erheblichen Verformungen bzw. Verwerfungen des Prüflings, was zu zusätzlichen (neuen) Fehlern in den Leiterbahnen oder gar zum Bruch der Leiterplatte führen kann - letzteres insbesondere bei Keramikplatten. Bei einer einseitigen Prüfung von Leiterplatten kann eine ungleichmäßige Verteilung oder örtliche Konzentrierung von Prüfstiften nicht zu einem solchen nachteiligen Effekt führen, weil das Widerlager auf der anderen Seite des Prüflings eine stabile Platte der eigentlichen Prüfvorrichtung sein kann, wobei diese Platte alle ungleichmäßigen Krafteinleitungen in die Leiterplatte im wesentlichen ohne Verwerfungen aufnimmt und somit die zu prüfende Leiterplatte in einem weitgehend unverformten Zustand abstützt. Bei einer gleichzeitig zweiseitigen Prüfung von Leiterplatten ist dies jedoch nicht möglich, weil das Widerlager bei lokal begrenzt fehlenden Prüfstiften auf der anderen Seite des Prüflings somit entweder nicht vorhanden ist oder die prüflingsspezifisch gebohrte Adapterplatte des anderen Adapters ist, wobei diese Adapterplatte nicht beliebig starr gemacht werden kann, zumal sie häufig aus Acrylglas oder dergl. hergestellt wird, um den manuellen Bestückungsvorgang des Adapters zu erleichtern. Bisher wurden also die Adapter für die beiden Seiten einer zweiseitig prüfenden Leiterplattenprüfvorrichtung unterschiedlich aufgebaut, was einen erheblichen zusätzlichen Aufwand darstellte.

Es ist hiernach die der vorliegenden Erfindung zugrundeliegende Aufgabe, einen Adapter für Leiterplattenprüfvorrichtungen anzugeben, der ähnlich wie die bekannten Adapter für einseitige Prüfung schnell und billig herstellbar ist, der aber sowohl für eine einseitige als auch für eine gleichzeitig beidseitige Prüfung von Leiterplatten einsetzbar ist, d.h. daß er in identischer grundsätzlicher Ausgestaltung für beide Seiten einer Leiterplattenprüfvorrichtung zum Einsatz kommen kann und dabei die Vorteile der bisherigen Adapter in sich vereinigt.

Diese Aufgabe wird erfindungsgemäß durch den Adapter gemäß Patentanspruch 1 gelöst. Durch diese neuartige Ausgestaltung wird ein mit Starrstiften aufgebauter, auf ein "aktives Grundraster" wirkender Adapter vorgesehen, der mit dem gleichen grundsätzlichen Aufbau für die ein und zweiseitige Prüfung von Leiterplatten Verwendung finden kann. Durch den einheitlichen Aufbau des Adapters - gleichgültig ob für einseitige oder für gleichzeitig zweiseitige Prüfung - sind alle Zusatzvorrichtungen wie z.B. Stiftsetzvorrichtungen, die einen derartigen Adapter aufbauen, stets dieselben. Zwischen der äußeren Adapterplatte und der Grundplatte wird eine weitere innere Adapterplatte vorgesehen und die Prüfstifte im Bereich zwischen der inneren und äußeren Adapterplatte erhalten eine Querschnittsverbreiterung, deren Breite größer ist als der Durchmesser der prüflingspezifischen Bohrungen in diesen Adapterplatten. Dadurch wird erreicht, daß die Prüfstifte beim Hantieren mit dem mit Prüfstiften bestückten Adapter unabhängig von der eigentlichen elektronischen Prüfvorrichtung nicht herausfallen.

Der federnde Abstandshalter kann besonders preiswert hergetellt werden, wenn er als ein im wesentlichen ringförmiges Federelement (Anspruch 2) ausgebildet wird, und zwar insbesondere dann, wenn es als massenhaft produziertes Kunststoffspritzteil (Anspruch 3) hergestellt wird.

Zum Einsatz dieses erfindungsgemäßen Adapters für die gleichzeitige beidseitige Prüfung von Leiterplatten muß man nur - soweit erforderlich - gemäß Anspruch 4 dafür sorgen, daß die mindestens eine Adapterplatine, d.h. die an der zu prüfenden Leiterplatte anliegende Adapterplatte in den Bereichen geringerer Prüfstiftdichte im Verhältnis zu der Prüfstiftdichte auf der anderen Seite der zu prüfenden Leiterplatte durch zusätzliche geeignete Abstützmittel unterstützt wird, um auf diese Weise eine Ausbiegung oder Verwerfung der äußeren Adapterplatte zu vermeiden, die bei fehlenden Prüfstiften als Auflager für die Leiterplatte dient, wenn keine oder wenige Kontaktstifte auf der einen Seite der Leiterplatte angreifen, um dem Kontaktdruck einer größeren, auf die andere Leiterplattenseite wirkenden Kontaktstiftzahl entgegenzuwirken. Es ist denkbar, diese zusätzlichen Abstützmittel für die mindestens eine Adapterplatte in unterschiedlichen

Ausgestaltungen vorzusehen, so beispielsweise als Balken oder Querträger, der unterhalb dieser (äußeren) Adapterplatte durchgeführt wird und außerhalb des Kontaktstiftfeldes abgestützt wird, doch wird gegenwärtig eine Ausgestaltung dieser Abstütztmittel bevorzugt, wie sie im Anspruch 5 näher gekennzeichnet ist. Danach haben die Abstützmittel die Form von separaten federnden Stützstiften, die die Unterseite der äußeren Adapterplatte abstützen und im wesentlichen senkrecht dazu durch zusätzliche Bohrungen in der eventuell vorhandenen inneren Adapterplatte bis zu der auf der eigentlichen Prüfvorrichtung aufliegenden Grundplatte verlaufen, in die die von der äußere Adapterplatte aufgenommene Belastung abgeleitet wird. Dies bedeutet also, daß, wenn auf der einen Seite der zu prüfenden Leiterplatte in einem bestimmten Bereich zu wenige Kontaktstifte im Verhältnis zu der Kontaktstiftzahl auf der anderen Seite der Leiterplatte vorgesehen sind (weil dort weniger Kontaktpunkte vorhanden sind), zusätzlich einige Stützstifte zwischen der äußeren Adapterplatte und der Grundplatte des Adapters eingesetzt werden, wobei für diese Stützstifte immer Platz ist, weil sie nur dort benötigt werden, wo eine geringere Anzahl an Kontaktstiften vorgesehen ist.

Die Stützstifte sind in Längsrichtung federnd ausgestaltet. Dadurch wird bei dem variablem Abstand zwischen der mindestens einen (äußeren) Adapterplatte und der Grundplatte ein entsprechend zur Belastung proportionaler Gegendruck durch die Stützstifte aufgebaut.

Ein Ausführungsbeispiel der vorliegenden Erfindung wird nachfolgend unter Bezugnahme auf die beigefügten Zeichnungen beschrieben. Darin zeigt:

Fig. 1 den grundsätzlichen Aufbau eines erfindungsgemäßen Adapters;

Fig. 2 den Einsatz zweier Adapter des grundsätzlichen Aufbaues der Fig. 1 beim beidseitig gleichzeitigem Prüfen einer Leiterplatte in einer nicht näher dargestellten elektronischen Prüfvorrichtung, die für diese Zwecke konzipiert ist;

Fig. 3 den grundsätzlichen Aufbau des "aktiven" Kontakt-Grundfeldes bzw. -Rasters der Prüfvorrichtung, welches durch den erfindungsgemäßen Adapter mit dem Prüfling verbunden wird;

Fig. 4 eine Ausführungsform eines erfindungsgemäßem Abstützmittels in Form eines federnden Stiftes;-

Fig. 5 eine Ausführungsform eines federnden Abstandshalters zwischen der Grundplatte und den beiden Adapterplatten; und

Fig. 6 verschiedene Ausführungsformen von im Rahmen des erfindungsgemäßen Adapters verwendbaren Kontaktstiften.

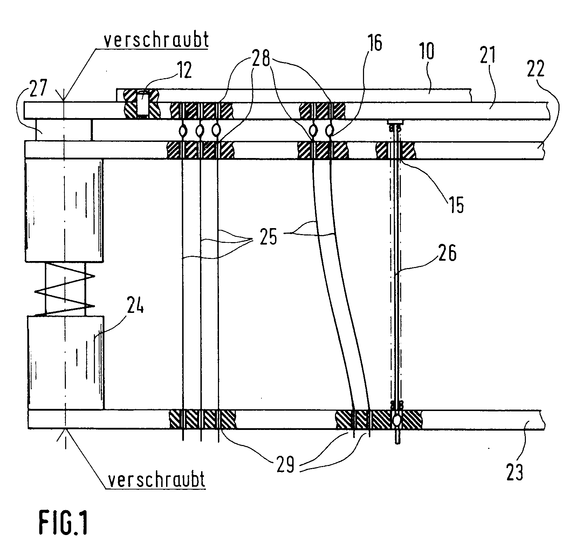

Der erfindungsgemäße Adapter besteht aus drei Platten, die über federnde Abstandselemente und Distanzstücke miteinander verbunden sind. Insbesondere ist die Grundplatte 23 über einen in Längsrichtung federnden Abstandshalter 24 mit der inneen Adapterplatte 22 verbunden, die ihrerseits über ein Distanzstück 27 mit der äußeren Adapterplatte 21 verschraubt ist. Die beiden Adapterplatten 21 und 22 sind entsprechend dem Muster der zu prüfenden Kontakte auf der zu prüfenden Leiterplatte 10 (Prüfling) mit (prüflingspezifischen) Adapterplattenbohrungen 28 versehen, d.h., das Bohrungsmuster in den beiden Platten 21 und 22 ist insoweit identisch, als diese Bohrungen für den Durchtritt der Prüfstifte 25 vorgesehen sind. Die innere Adapterplatte 22, 32 muß zusätzlich mit weiteren Stützstiftbohrungen 15 versehen werden. Die Adapterplatten sind aus elektrisch nicht leitendem Material wie z.B. Plexiglas, Epoxyd, GFK-Platten etc. hergestellt. Die untere Grund(Raster)-Platte 23 des Adapters gemäß der Fig. 1 ist entsprchend dem Muster der Kontakte der Leiterplattenprüfvorrichtung mit Grundrasterkanälen 29 versehen, die beispielsweise durch Bohren oder dergleichen hergestellt werden. Dies bedeutet, daß die Grundrasterplatte 23 mit völlig gleichmäßig verteilten Kanälen entsprechend dem Muster der Kontakte der Leiterplattenprüfvorrichtung versehen ist, während die beiden Adapterplatten 21 und 22 mit eventuell unregelmäßig verteilten, prüflingspezifischen Adapterplattenbohrungen 28 versehen sind. Zwischen diesen Grundrasterkanälen 29 und der Adapterplattenbohrungen 28 erstrecken sich die Prüfstifte 25, die die elektrische Verbindung zwischen den Kontakten der Prüfvorrichtung und den Anschlußpunkten der zu prüfenden Leiterplatte 10 herstellen. Wie in der Fig. 1 angedeutet ist, kann ein Teil dieser Prüfstifte in ihrem unteren, der Grundrasterplatte 23 zugewandten Abschnitt flexibel auslenkbar sein, um eventuelle Fluchtungsfehler zwischen den Adapterplattenbohrungen 28 und den Grundrasterkanälen 29 auszugleichen oder um eine Anpassung an lokale Erhöhungen der Kontaktpunktdichte auf der zu prüfenden Leiterplatte 10 zu schaffen.

Damit die Prüfstifte 25 beim Hantieren mit dem Adapter gemäß Fig. 1 nicht herausfallen, sind die Prüfstifte im Bereich zwischen den beiden Adapterplatten 21 und 22 mit einer Querschnittsverbreiterung oder Prüfstiftverdickung 16 versehen, deren Breite größer ist als der Durchmesser der Adapterplattenbohrungen 28. Eine solche Prüfstiftverdickung kann beispielsweise bei einem ansonsten glatten, konturlosen Prüfstift in einfacher Weise dadurch hergestellt werden, daß er in diesem Bereich durch geeignete Mittel gequetscht wird. Andere Möglichkeiten hierfür sind aus den Ausführungsformen der Fig. 6 ersichtlich.

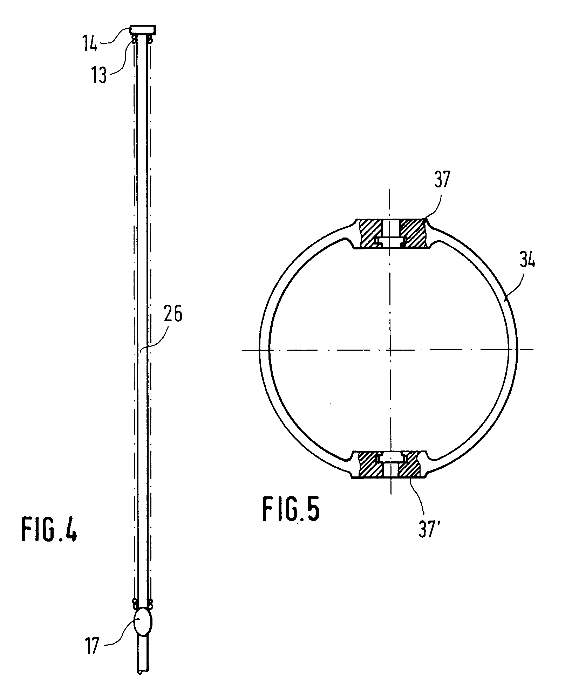

Bei Bedarf werden in Bereichen verringerter Prüfstiftdichte zusätzliche Stützstifte 26 zwischen der äußeren Adapterplatte 21 und der Grundrasterplatte 23 eingesetzt. Zu diesem Zweck werden in denjenigen Bereichen der inneren Adapterplatte 22, die weniger Bohrungen 28 enthalten, nach Augenschein oder aufgrund einer exakten Berechnung zusätzliche Stützstiftbohrugnen 15 vorgesehen, in die dann nach dem Bestücken des Adapters der Fig. 1 (bei abgenommener äußerer Adapterplatte 21) die Stützstifte 26 - etwa gemäß Fig. 4 - eingesetzt werden. Die Stützstifte 26 bestehen aus einem Stift mit einem Kopf 14 und einer Feder 13, die um diesen Stift 26 gewickelt ist. Beispielsweise durch eine Querschnittsverformung 17 am unteren Ende des Stützstiftes bleibt die Druckfeder 13 bei herausgenommenem Stützstift mit diesem verbunden. Wie in Fig. 1 gezeigt ist, liegt der Kopf 14 des Stützstiftes an der unteren, d.h. leiterplattenabgewandten Seite der äußeren Adapterplatte 21 an, während das untere Ende des Stützstiftes sowie der Bereich der Querschnittsverformung 17 in einem Kanal 29 der Grundrasterplatte 23 angeordnet ist. Die Feder 13 liegt an der Grundrasterplatte 23 an, weil ihr Durchmesser größer ist als der Durchmesser der Kanäle 29. Auf diese Weise können die Stützstifte 26 eine übermäßige lokale Belastung der äußeren Adapterplatten 21 abfangen und über die Feder 13 in die Grundplatte 23 übertragen. Diese liegt an den Isolierstoffblöcken 41 des Kontakt-Grundfeldes 40 auf und stützt sich auf diesen ab.

In der äußeren Adapterplatte 21 kann ein Fixierstift 12 vorgesehen sein, um den Prüfling 10 mit Hilfe einer entsprechenden Fixierstiftbohrung im Verhältnis zu den Prüfstiften 25 bzw. den prüflingspezifischen Adapterplattenbohrungen 28 genau anzuordnen. Der Prüfling 10 wird also durch diesen Fixierstift zum Adapter zentriert, so daß die Lage der Kontaktpunkte auf dem Prüfling mit der Lage der Prüfstifte im Adapter übereinstimmt.

Der Bohrungsdurchmesser in den prüflingspezifischen Platten des Adapters ist etwas größer als der Durchmesser der verwendeten Starrstifte (z.B. Starrstift mit mit 0,8 mm Durchmesser, Bohrungen 28 in den Adapterplatten 0,85 mm bis 0,9 mm Durchmesser.

Am Rand der Adapterplatten 21, 22, d.h. außerhalb des Feldes der prüflingspezifischen Adapterplattenbohrungen 28 sind zusätzliche Montagebohrungen (nicht dargestellt) zum Verschrauben der Platten 21, 22 mit dem Distanzstück 27 bzw. dem Abstandshalter 24 oder 34 vorgesehen. Ähnliche Montagebohrungen gibt auch in der Grundraster platte 23.

Wie bereits angesprochen, ist die Grundrasterplate 23 im Raster der Kontaktpunkte des Prüfgerätes gebohrt bzw. mit Kanälen 29 versehen. Der Durchmesser dieser Bohrungen ist so festgelegt, daß Prüfstifte mit unterschiedlichen Durchmesser bzw. Querschnitt sowie die Stützstifte 26 eingesetzt werden können. Die Bohrungen der Grundrasterplatte 23 sollen zusätzlich angesenkt werden, d.h. mit einem kleinen Einlaßtrichter versehen werden, damit das Bestücken des Adapters mit den Prüfstiften erleichtert wird. Die Grundrasterplatte 23 und zumindest die innere Adapterplatte 22 sollen aus durchsichtigem Material gefertigt sein, damit das manuelle Bestücken des Adapters erleichtert wird und die visuelle Prüfung auf Kurzschlüsse zwischen den Stiften 25 des Adapters ohne weiteres erfolgen kann. Natürlich erfolgt die Bestückung des Adapters mit den Stiften 25 bzw. bei Bedarf auch mit den Stützstiften 26 bei abgenommener äußerer Adapterplatte 21, die dann anschließend nach dem fertigen Bestücken des Adapters aufgesetzt und mit dem Distanzstück 27 verschraubt wird, um die Prüfstifte und Stützstifte in dem Adapter zu sichern.

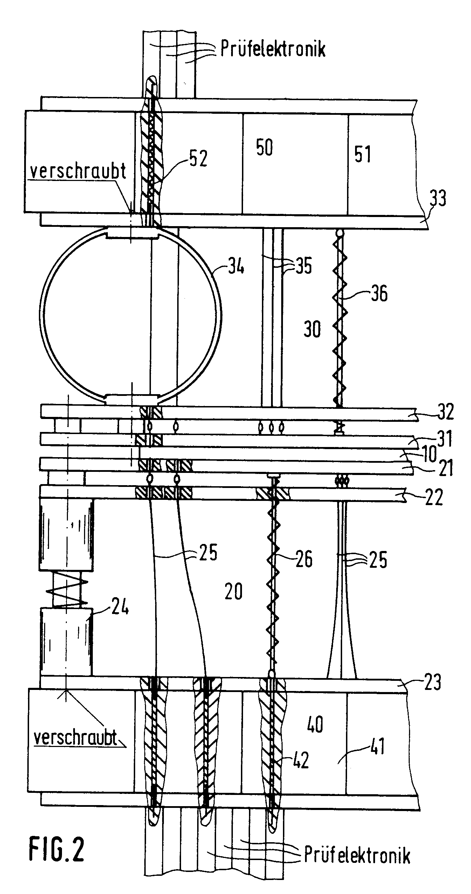

Die beiden im Verhältnis zueinander durch ein Distanzstück 27 festgelegten Adapterplatten 21 und 22 werden relativ zur Grundrasterplatte 23 durch einen Abstandshalter 24 gehalten, der im konkreten Ausführungsbeispiel der Fig. 1 bzw. 2 in Längsrichtung federnd ausgestaltet ist. Eine alternative Ausgestaltung eines solchen federnden Abstandshalters ist in Fig. 2 mit dem Bezugszeichen 34 bezeichnet. Ein solcher federnder Stützring ist auch in Fig. 5 gezeigt und kann ein Rohrstück in entsprechenden Abmessungen mit Montagebohrungen oder ein Kunststoffspritzteil sein. Durch den Einsatz eines derartigen federnden Abstandselementes, etwa in Form einer geschlossenen oder offenen Blattfeder, werden die Adapterkosten niedrig gehalten. Beim Andrücken des Prüflings auf die Prüfstifte bewegen sich die prüflingsspezifischen Adapterplatten 21 und 22 mit den Starrstiften gemäß der Ausführungsform der Fig. 1 nach unten, wobei der Axialverschiebung der Prüfstifte 25 nach unten von den federnden Kontaktelementen 42 des unteren (aktiven) Kontakt-Grundfeldrasters 40 entgegengewirkt wird, während der Abstandshalter 24 oder 34 in entsprechendem Maße verformt wird. Dies gilt letztlich auch für die Druckfeder 13 des Stützstiftes 26.

In der Fig. 2 ist eine Adapteranordnung mit zwei Adaptern gemäß Fig. 1 zum gleichzeitig beidseitigen Kontaktieren eines Prüflings 10 dargestellt. Die beiden Adapter sind - bis auf die alternativ ausgebildeten federnden Abstandshalter 24 bzw. 34 - identisch ausgebildet. Der Adapter 20 dient zum Kontaktieren der Prüflingsunterseite und der Adapter 30 dient zum Kontaktieren der Prüflingsoberseite. Der untere Adapter 20 liegt auf dem unteren Kontakt-Grundfeld 40 des nicht näher dargestellten Leiterplattenprüfgerätes auf, wobei das Grundfeld des Testgerätes mit federnden Kontaktelementen 42 ausgerüstet ist. Diese federnden Kontaktelemente sind in den Bohrungen eines Isolierstoffblockes 41 eingesetzt und sind über Steckelemente mit der Prüfelektronik des eigentlichen Leiterplattenprüfgerätes verbunden. Die federnden Kontakte des Kontaktfeldes sind also dem Prüfgerät zugeordnet.

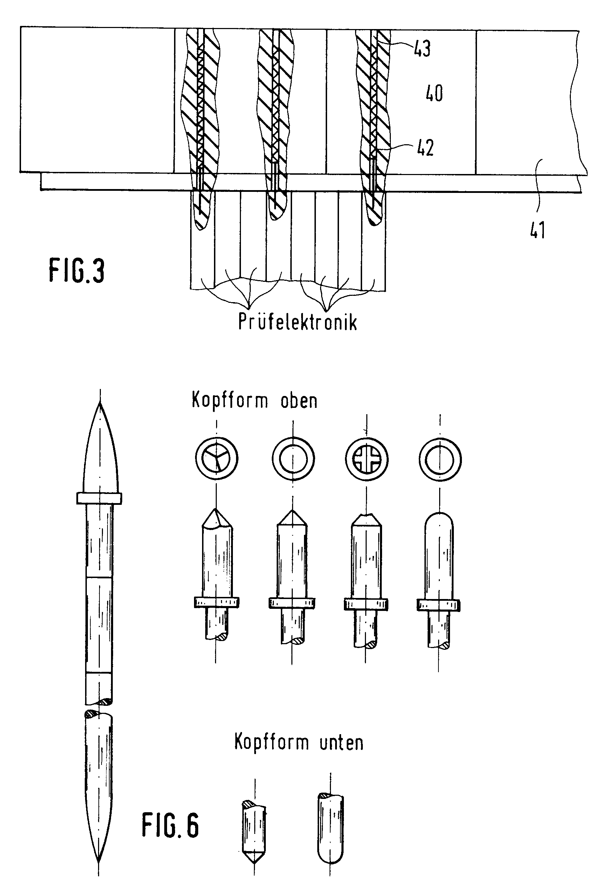

Der obere Adapter 30 ist am oberen Kontakt-Grundfeld 50 des Leiterplattenprüfgerätes angebracht. Das obere Kontakt-Grundfeld 50 des Testgerätes ist wie das untere Grundfeld 40 aufgebaut. Beide Kontakt-Grundfelder 40 und 50 können über einen geeigneten, nicht näher dargestellten Mechanismus aufeinander zu bewegt werden, wobei die Prüfelektronik mitbewegt wird. Der Abstand zwischen dem unteren und dem oberen Kontakt-Grundfeld 40 bzw. 50 wird also verkleinert. Die starren Prüfstifte 25, 35 beider Adapter 20, 30 treten durch die rasterförmig angeordneten Bohrungen der Grundplatten 23, 33 in die entsprechenden Bohrungen (z.B. 43 in Fig. 3) des aktiven Grundrasterfeldes 40, 50 ein, so daß die Federkontaktelemente 42, 52 zusammengedrückt werden. Gleichzeitig verändern sich die Abstände zwischen den Grundrasterplatten 23 und 33 und den prüflingsspezifischen Adapterplatten 21, 22 bzw. 31, 32, weil diese Adapterplatten über federnde Abstandshalter 24 bzw. 34 gehalten werden.

Die Stützstifte 26 tauchen ebenfalls in die Bohrungen (z.B. 43 in Fig. 3) der Kontakt-Grundfeldraster 40 bzw. 50 des Leiterplattenprüfgerätes ein, wobei die Druckfedern 13 der Stützstifte 26 zusammengedrückt werden. Die Prüfstifte 25 des unteren Adaptes 20 drücken den Prüfling 10 gegen die äußere prüflingsspezifische Adapterplatte 31 des oberen Adapters 30, wobei diese Platte 31 durch die Stützstifte 36 unterstützt ist. In gleicher Weise drücken die Prüfstifte 35 des oberen Adapters 30 den Prüfling 10 gegen die äußere prüflingsspezifische Platte 21 des unteren Adapters 20, wobei diese Platte 21 ihrerseits durch die Stützstifte 26 unterstützt wird. Der Prüfling 10 wird also zwischen den beiden äußeren prüflingsspezifischen Adapterplatten 21 bzw. 22 eingespannt und kann sich nur verformen, wenn die prüflingsspezifischen Adapterplatten auch verformt werden, was aber durch die Stützstifte 26 bzw. 36 weitgehend verhindert wird.

Da die Druckfeder 13 der Stützstifte 26 die Andruckkraft von mehreren Prüfstiften ausgleichen kann, werden in den Adapter relativ wenige Stützstifte 26 eingesetzt. Anzahl und Abstand der Stützstifte zueinander sind von der Anzahl der Prüfstifte zum Kontaktieren der beiden Prüflingsseiten abhängig und die Anordnung der Stützstifte kann aufgrund einer Schätzung nach Augenschein oder aufgrund einer genauen Rechnung vorgenommen werden.

Beim doppelseitigen Kontaktieren eines Prüflings gemäß der Fig. 2 wird, wie dargestellt, für jede Prüflingsseite ein Adapter eingesetzt. Dabei können die beiden Adapter zueinander über nicht näher dargestellte Zentrierstifte ausgerichtet werden. Zu diesem Zweck werden für die Zentrierstifte in den prüflingsspezifischen Adapterplatten 31 bzw. 21 Aufnahmebohrungen außerhalb des Bohrbildes der Kontaktpunkte gebohrt.

Die Montage und Bestückung eines Adapters gemäß dem Ausführungsbeispiel geschieht in der Weise, daß die Grundrasterplatte und die innere prüflingsspezifische Adapterplatte auf dem federnden Abstandshalter montiert werden. Die Prüfstifte werden anschließend durch die Bohrungen in der Adapterplatte eingesetzt und können bei Bedarf - etwa einer hohen Prüfpunktkonzentration in lokalen Bereichen der Leiterplatte - um mehrere Millimeter seitwärts ausgelenkt werden. Das Bestücken des Adapters mit den Prüfstiften kann manuell oder durch einen Automaten erfolgen. Anschließend wird die äußere Adapterplatte aufgesetzt. Sind die zwei Adapterplatten durchsichtig, kann visuell nachgeprüft werden, ob die Prüfstifte sich berühren und Kurzschlüsse entstehen. Mit dem bestückten Adapter kann dann ein Adaptertest auf dem Prüfgerät erfolgen, um die Anzahl und Anordnung der Prüfstifte nachzuprüfen und festzustellen, ob Kurzschlüsse im Adapter vorhanden sind.

Bezugszeichenliste

| 10 | Leiterplatte/Prüfling |
| 11 | |
| 12 | Fixierstift |
| 13 | Stützstiftfeder |
| 14 | Stützstiftkopf |
| 15 | Stützstiftbohrung |
| 16 | Prüfstiftverdickung |
| 17 | Stützstiftverformung |
| 18 | |
| 19 | |
| 20 | unterer Adapter |
| 21 | äußere Adapterplatte |
| 22 | innere Adapterplatte |
| 23 | Grund(raster)platte |
| 24 | (federnder) Abstandshalter |
| 25 | (starre) Prüfstifte |
| 26 | Stutzstift (federnd) |
| 27 | Distanzstuck |
| 28 | pruflingsspe. Adapterplattenbohrungen |
| 29 | Grundrasterkanäle |
| 30 | oberer Adapter |
| 31 | äußere Adapterplatte |
| 32 | innere Adapterplatte |
| 33 | Grund(raster)platte |

34 federnder Abstandshalter
35 (starre) Prüfstifte
36 (Stützstift (federnd)
37 Anschlußbereich
38
39 Grundrasterkanäle
40 unteres ("aktives") Kontakt-Grundfeld/raster
41 Isolierstoffblock
42 federnde Kontaktelemente
43 Bohrungen des Kontakt-Grundfeld/rasters
44
45
46
47
48
49
50 oberes ("aktives ) Kontakt-Grundfeld/-raster
51 Isolierstoffblock
52 federnde Kontaktelemente
53 Bohrungen des Kontakt-Grundrasters

## Patentansprüche

1. Adapter zur Anpassung des gleichmäßigen Kontaktrasters einer elektronischen Prüfvorrichtung für Leiterplatten an die ungleichmäßige Kontaktkonfiguration der Anschlußpunkte auf einer zu prüfenden Leiterplatte (10),
   - mit einer Grundplatte (23, 33), die entsprechend dem Kontaktraster der Prüfvorrichtung gebohrte Kanäle (29) besitzt und planparallel zum Grundraster der Prüfvorrichtung auf diesem aufliegt,
   - mit einer äußeren Adapterplatte (21, 31), die deckungsgleich zu der ihr zugewandten Kontaktkonfiguration der Anschlußpunkte der zu prüfenden Leiterplatte (10) mit Bohrungen (28) versehen und zur Anlage an der zu prüfenden Leiterplatte (10) vorgesehen ist,
   - mit außerhalb des Kontaktrasters angeordneten Abstandshaltern (24, 34), die vertikal zur Grundplatte (23, 33) und zur äußeren Adapterplatte (21, 31) verlaufen und letztere auf der vom Grundraster der Prüfvorrichtung abgewandten Seite der Grundplatte (23, 33) planparallel zu und mit Abstand von dieser anordnen,
   - und mit in Längsrichtung starren nadelartigen Prüfstiften (25, 35), die mit ihrem einen Ende auf den in Längsrichtung federnd gelagerten Kontakten des Kontaktrasters der Prüfvorrichtung aufliegend sich durch die Kanäle (29) der Grundplatte und die Bohrungen (28) der äußeren Adapterplatte (21, 31) erstrecken sowie mit ihren anderen Enden die Anschlußpunkte der zu prüfenden Leiterplatte (10) kontaktieren,
dadurch gekennzeichnet, daß eine weitere, ebenfalls deckungsgleich zu der ihr zugewandten Kontaktkonfiguration der Anschlußpunkte der zu prüfenden Leiterplatte (10) gebohrte innere Adapterplatte (22, 32) vorgesehen ist, die zwischen der äußeren Adapterplatte (21, 31) und der Grundplatte (23, 33) angeordnet ist und die mit der äußeren Adapterplatte (21, 31) über ein Distanzstück (27) in festem Abstand und mit der Grundplatte (23, 33) über die in Längsrichtung federnden Abstandshalter (24, 34) verbunden ist,
und daß die Prüfstifte (25, 35) im Bereich zwischen der inneren und der äußeren Adapterplatte (22 bzw. 21, 32 bzw. 31) mit je einer gequetschten Querschnittsverbreiterung (16) zur Festlegung in Längsrichtung versehen sind.

2. Adapter nach Anspruch 1, dadurch gekennzeichnet, daß die Abstandshalter (24) als im wesentlichen ringförmige Federelemente (34) mit je zwei auf dem Umfang angeordneten, senkrecht zum Durchmesser ausgerichteten ebenen Anschlußbereichen (37, 37') für die innere Adapterplatte (22) bzw. für die Grundplatte (23) ausgebildet sind.

3. Adapter nach Anspruch 2, dadurch gekennzeichnet, daß jedes ringförmige Federelement (34) als Kunststoffspritzteil ausgestaltet ist.

4. Adapter nach Anspruch 1, dadurch gekennzeichnet, daß die Querschnittsverbreiterung der Prüfstifte größer ist als der Durchmesser der prüflingsspezifischen Bohrungen (28) in diesen Adapterplatten (21 bzw. 22).

5. Adapter nach einem der voranstehenden Ansprüche, dadurch gekennzeichnet, daß die äußere Adapterplatte (21, 31) zum Bestücken des Adapters mit Prüfstiften abnehmbar ausgebildet ist.

6. Adapter nach einem der Ansprüche 1 bis 5, dadurch gekennzeichnet, daß für die gleichzeitige beidseitige Prüfung von Leiterplatten die mit der zu prüfenden Leiterplatte in Kontakt kommende äußere Adapterplatte (21, 31) des Adapters in Bereichen geringerer Prüfstiftdichte durch geeignete Abstützmittel abgestützt ist, um Verwerfungen oder Ausbiegungen der bei fehlenden Prüfstiften als Auflager für die Leiterplatte dienenden äußeren Adapterplatte (21, 31) aufgrund des Kontaktdruckes der auf die andere Leiterplattenseite wirkenden Kontaktstifte (25, 35) zu vermeiden.

7. Adapter nach Anspruch 6, dadurch gekennzeichnet, daß die Abstützmittel in Längsrichtung gefederte Stützstifte (26, 36) sind, die an der Unterseite der äußeren Adapterplatte (21, 31) angreifen und sich im wesentlichen senkrecht dazu bis zu der auf der Prüfvorrichtung aufliegenden Grundplatte (23, 33) erstrecken, in die die von der äußeren Adapterplatte aufgenommene Belastung abgeleitet wird.

## Claims

1. An adapter for adapting the regular contact grid of an electronic testing device for printed circuit boards to the irregular contact configuration of the connection points on a circuit board (10) which is to be tested,
   - with a base plate (23, 33), which has bored channels (29) corresponding to the contact grid of the testing device and lies on the base grid of the testing device so as to be plane-parallel thereto,
   - with an outer adapter plate (21, 31) which is provided with bores (28) congruently to the contact configuration, facing said plate, of the connection points of the circuit board (10) which is to be tested and is intended to lie on the circuit board (10) which is to be tested,
   - with spacers (24, 34) arranged outside the contact grid, which spacers extend vertically to the base plate (23, 33) and to the outer adapter plate (21, 31) and arrange the latter on the side of the base plate (23, 33) remote from the base grid of the testing device so as to be plane-parallel thereto and at a distance therefrom,
   - and with needle-like test prods (25, 35) which are rigid in the longitudinal direction and which extend through the channels (29) in the base plate and the bores (28) in the outer adapter plate (21, 31) with one end, lying on the contacts of the contact grid of the testing device which are resiliently mounted in the longitudinal direction, and contact the connection points of the circuit board (10) which is to be tested with their other ends, characterised in that an additional inner adapter plate (22, 32), likewise bored congruently to the contact configuration of the connection points which faces it of the circuit board (10) which is to be tested, is provided which is located between the outer adapter plate (21, 31) and the base plate (23, 33) and which is connected to the outer adapter plate (21, 31) by means of a separator piece (27) at a fixed distance and to the base plate (23, 33) by means of the spacers (24, 34) which are resilient in the longitudinal direction, and that the test prods (25, 35) in the region between the inner and the outer adapter plate (22 or 21, 32 or 31 respectively) are each provided with a squashed widened cross-section (16) for fixing in the longitudinal direction.

2. An adapter according to Claim 1, characterised in that the spacers (24) are designed as substantially annular spring elements (34) each having two flat connection regions (37, 37') for the inner adapter plate (22) or for the base plate (23), which regions are located on the circumference and oriented at right angles to the diameter.

3. An adapter according to Claim 2, characterised in that each annular spring element (34) is designed as a moulded plastic part.

4. An adapter according to Claim 1, characterised in that the widened cross-section of the test prods is larger than the diameter of the bores (28) in these adapter plates (21 or 22 respectively) which are specific to the test piece.

5. An adapter according to one of the preceding Claims, characterised in that the outer adapter plate (21, 31) is designed to be removable for equipping the adapter with test prods.

6. An adapter according to one of Claims 1 to 5, characterised in that for the simultaneous two-sided testing of circuit boards the outer adapter plate (21, 31) of the adapter which comes into contact with the circuit board which is to be tested is supported in regions of lesser test prod density by suitable supporting means, in order to avoid warping or deflection, due to the contact pressure of the contact pins (25, 35) acting on the other side of the circuit board, of the outer adapter plate (21, 31), which if test prods are lacking acts as a support for the circuit plate.

7. An adapter according to Claim 6, characterised in that the supporting means are supporting pins (26, 36) which are resilient in the longitudinal direction, which act on the underside of the outer adapter plate (21, 31) and extend substantially perpendicular thereto as far as the base plate (23, 33) which lies on the testing device, into which plate the stress received by the outer adapter plate is diverted.

## Revendications

1. Adaptateur pour l'adaptation de la grille de contact régulière d'un dispositif électronique de test, pour des circuits imprimés, à la configuration de contacts irrégulière des points de connexion sur un circuit imprimé (10) à tester, comprenant :
   - une plaque de base (23, 33) qui comporte, conformément à la grille de contacts du dispositif de test, des canaux percés (29) et qui est appliquée, plan-parallèlement à la grille de base du dispositif de test, sur cette grille,
   - une plaque externe d'adaptation (21, 31) qui est pourvue de trous (28) de façon à coïncider à la configuration de contacts, tournée vers cette plaque, des points de connexion du circuit imprimé (10) à tester et qui est prévue en appui sur le circuit imprimé (10) à tester,
   - des entretoises (24, 34) qui sont agencées en dehors de la grille de contacts, qui s'étendent verticalement par rapport à la plaque de base (23, 33) et à la plaque externe d'adaptation (21, 31) et qui agencent cette dernière plaque, sur le côté de la plaque de base (23, 33) tourné à l'écart de la grille de base du dispositif de test, plan-parallèlement à et à distance de cette plaque de base,
   - et, en direction longitudinale, des broches de test (25, 35) rigides, en genre d'aiguille, qui, en appui par une de leurs extrémités sur les contacts de la grille de contact du dispositif de test et montés de façon à faire ressort en direction longitudinale, s'étendent au travers des canaux (29) de la plaque de base et au travers des trous (28) de la plaque externe d'adaptation (21, 31) et qui, par leur autre extrémité, sont en contact avec les points de connexion du circuit imprimé (10) à tester,

   caractérisé en ce qu'est prévue une autre plaque interne d'adaptation (22, 32) qui est trouée aussi de façon à coïncider à la configuration de contacts, tournée vers cette plaque, des points de connexion du circuit imprimé (10) à tester, qui est agencée entre la plaque externe d'adaptation (21, 31) et la plaque de base (23, 33) et qui est raccordée à la plaque externe d'adaptation (21, 31), à distance fixe, par un élément d'écartement (27) et à la plaque de base (23, 33) par les entretoises (24, 34) qui font ressort en direction longitudinale, et en ce que les broches de test (25, 35) sont pourvues, dans la zone entre les plaques externe et interne d'adaptation (22 et respectivement 21, 32 et respectivement 31), de chaque fois un élargissement écrasé (16) de section transversale pour la fixation en direction longitudinale.

2. Adaptateur suivant la revendication 1, caractérisé en ce que les entretoises (24) sont réalisées sous la forme d'éléments de ressort (34) sensiblement annulaires avec chaque fois deux zones de raccordement planes (37, 37'), orientées perpendiculairement au diamètre et agencées sur le pourtour, pour la plaque interne d'adaptation (22) ou respectivement pour la plaque de base (23).

3. Adaptateur suivant la revendication 2, caractérisé en ce que chaque élément de ressort annulaire (34) est façonné sous la forme d'une partie injectée en matière synthétique.

4. Adaptateur suivant la revendication 1, caractérisé en ce que l'élargissement de section transversale des broches de test est supérieur au diamètre des trous (28), spécifiques aux éléments de test, dans ces plaques d'adaptation (21 et respectivement 22).

5. Adaptateur suivant l'une quelconque des revendications précédentes, caractérisé en ce que la plaque externe d'adaptation (21, 31) est réalisée de façon démontable pour l'équipement de l'adaptateur avec des broches de test.

6. Adaptateur suivant l'une quelconque des revendications 1 à 5, caractérisé en ce que, pour le test simultané des deux côtés de circuits imprimés, la plaque externe (21, 31) de l'adaptateur, qui entre en contact avec le circuit imprimé à tester, est soutenue dans des zones de densité plus faible de broches de test par des moyens de soutien appropriés afin d'éviter des gauchissements ou des flexions de la plaque externe d'adaptation (21, 31), qui sert de support pour le circuit imprimé lorsque des broches de test manquent, en raison de la pression de contact des broches de contact (25, 35) agissant sur l'autre face des circuits imprimés.

7. Adaptateur suivant la revendication 6, caractérisé en ce que les moyens de soutien sont des broches de soutien (26, 36) qui font ressort en direction longitudinale, qui entrent en contact avec la face inférieure de la plaque externe d'adaptation (21, 31) et qui s'étendent sensiblement perpendiculairement à celle-ci jusqu'à

**EP 0 315 707 B1**

la plaque de base (23, 33) posée sur le dispositif de test et dans laquelle est détournée la sollicitation reçue de la plaque externe d'adaptation.

verschraubt

27　　12　　28　　16　10　　21　　22

25

15

26

24

29

verschraubt

23

# FIG.1

verschraubt

Prüfelektronik

52

50

51

33

34

35

36

30

32

31

10

21

22

25

26

25

24

20

verschraubt

23

40

42

41

FIG.2

Prüfelektronik

**FIG.3**

43

40

42

41

Prüfelektronik

Kopfform oben

Kopfform unten

**FIG.6**

FIG.4

FIG.5